**Europäisches Patentamt**

**European Patent Office**

**Office européen des brevets**

(19)

(11) Veröffentlichungsnummer: **0 168 518**
**B1**

(12) **EUROPÄISCHE PATENTSCHRIFT**

(45) Veröffentlichungstag der Patentschrift:
**20.04.88**

(51) Int. Cl.⁴: **G 01 R 27/00,** G 08 C 15/08,
G 01 K 7/16

(21) Anmeldenummer: **84108568.1**

(22) Anmeldetag: **20.07.84**

(54) **Tieftemperatur-Messschaltung.**

(43) Veröffentlichungstag der Anmeldung:
**22.01.86 Patentblatt 86/4**

(45) Bekanntmachung des Hinweises auf die Patenterteilung:
**20.04.88 Patentblatt 88/16**

(84) Benannte Vertragsstaaten:
**AT BE CH DE FR GB IT LI LU NL SE**

(56) Entgegenhaltungen:
**DE - A - 2 137 110**
**FR - A - 2 306 489**
**US - A - 3 479 586**
**US - A - 3 717 857**

**CERN Report CERN/EF/RF 81-4 v. 12. März 1981 (Fig. 1
& 9 , Text para. 1 & 2a,b,c)**

(73) Patentinhaber: **Deutsches Elektronen-Synchrotron
DESY, Notkestrasse 85, D-2000 Hamburg 52 (DE)**

(72) Erfinder: **Peters, Jens, Dipl.-Ing., Saturnweg 13,
D-2000 Hamburg 65 (DE)**

(74) Vertreter: **UEXKÜLL & STOLBERG Patentanwälte,
Beselerstrasse 4, D-2000 Hamburg 52 (DE)**

## Beschreibung

Die Erfindung betrifft eine Tieftemperatur-Messschaltung mit einer Anzahl von temperaturabhängigen Widerständen, mit mindestens einem die Widerstände ansteuernden Multiplexer, mit einer Konstantstromquelle, welche die Widerstände über den oder die Multiplexer mit Strom versorgt, mit einem an den oder die Multiplexer angeschossenen Verstärker zur Verstärkung des Spannungsabfalls über den Widerständen, und mit einer dem Verstärker nachgeschalteten Anzeige zum Anzeigen der über jedem einzelnen Widerstand gemessenen Spannungen.

Eine derartige Tieftemperatur-Messschaltung ist aus dem CERN-Report CERN/EF/RF 81-4 vom 12. März 1981 bekannt und dient dazu, bei zur Beschleunigung von Elektronen oder Positronen dienenden Hohlraumresonatoren, die aus Gründen der Strom-einsparung supraleitend betrieben werden, festzu-stellen, wann und an welcher Stelle die Temperatur so hoch ansteigt, dass die Supraleitung zusammenbricht. Zum Erreichen der Supraleitfähigkeit sind die aus Niob hergestellten Beschleunigungsschalen der Hohlraumresonatoren, die üblicherweise als «Cavities» bezeichnet werden, jeweils in einem Kryostaten untergebracht, welcher die Niob-Struktur in einem Bad aus flüssigem Helium aufnimmt und diese auf eine Temperatur von 4,2K kühlt. Zur Vorkühlung des Heliums dient ein das Bad umgebender Stickstoffmantel, welcher 77K erreicht. Der Kryostat besitzt üblicherweise noch ein Isolier-Vakuum, welches sowohl den Stickstoffmantel, also auch das Heliumbad als äusserste Isolierschicht umgibt. Ein derartiges Cavity ist in der DE-Patentanmeldung DE-A-3 346 178 beschrieben.

Um festzustellen, ob bzw. wo bei einem Niob-Cavity die Supraleitung durch Oberflächenfehler, Staub, Kratzer oder andere Einflüsse zusammenbricht und um damit den Nachbearbeitungsort der Niob-Struktur lokalisieren zu können, hat man auf der Aussenwand der Niob-Struktur bislang temperatur-abhängige Widerstände angebracht, deren Zulei-tungen in Form eines Kabelbaumes aus dem Kryostaten durch eine isolierende Durchführung nach aussen geführt wurden. Um eine einigermassen hinreichende Auflösung für die Fehlerlokalisierung zu erhalten, waren annähernd 1000 Widerstände erforderlich, so dass ein Kabelbaum mit 1000 Kabeln durch die erwähnte Durchführung aus dem Kryostaten und damit aus dem Tieftemperaturbereich nach aussen in den Bereich der Raumtemperatur geführt werden mussten. Ausserhalb des Kryostaten waren die temperaturabhängigen Widerstände mit einem Multiplexer verbunden, welcher die Widerstände nacheinander abfragte. Eine Spannungsquelle diente zur Spannungsversorgung der Widerstände, während der Spannungsabfall über die Widerstände festgestellt wurde.

Ein wesentlicher Nachteil der bekannten Schaltung besteht darin, dass eine zur Zahl der Sensoren proportionale Anzahl von Messkabeln aus dem Kryostaten nach aussen geführt werden muss, was zwangsläufig die Kabeldurchführung vergrössert und damit zu unzulässigen Wärmeflüssen in dem Kryostaten führt, die nur durch eine sehr aufwendige Vergrösserung des Helium-Verflüssigers beherrscht werden können.

Es ist Aufgabe der Erfindung, die Tieftemperatur-Messschaltung der eingangs erwähnten Art dahingehend weiterzubilden, dass bei gleichzeitiger Erhöhung der örtlichen Auflösung, d.h. der Zahl der Messstellen, die Zufuhr von Verlustwärme in tragbaren Grenzen gehalten wird.

Zur Lösung dieser Aufgabe dient eine Schaltung der eingangs genannten Art, welche dadurch gekennzeichnet ist, dass zusätzlich zu den Widerständen auch die Multiplexer, die Konstantstromquelle und der Verstärker in den im Betrieb flüssiges Helium enthaltenden Teil eines Kryostaten gelegt sind und dass die Multiplexer und der Verstärker in LOCMOS-Technologie ausgeführt sind. Als LOCMOS-Bauelemente können z.B. die Typen HEF 4515 sowie HEF 4051 als Multiplexer und der Typ HEF 4007 als Verstärker verwendet werden, d.s. Bauelemente der Firma VALVO, die sich durch höhere Geschwindigkeit und kleine Leistungsaufnahme auszeichnen.

Dadurch wird erreicht, dass eine grössere Anzahl von temperaturabhängigen Widerständen wie bisher auf der zu überwachenden Struktur unterbringbar ist, während sich die Zahl der aus dem Kryostaten nach aussen zu führenden Leitungen drastisch verringert. Anstelle von etwa 1000 Leitungen brauchen bei der erfindungsgemässen Schaltung lediglich etwa 30 Leitungen durch die den Tieftemperaturbereich vom Raumtemperaturbereich trennende Durchführung geführt zu werden. Es hat sich überraschend gezeigt, dass die ausgewählten LOCMOS-Halbleiterbauelemente für die Multiplexer und die Analogschalter auch noch im flüssigen Heliumbad zuverlässig arbeiten, obgleich man annahm, dass dies nicht der Fall sein würde. Ein Vorurteil bestand darin, dass bei einer Temperatur von 4,2K die Halb-leitereigenschaften der Bauelemente bereits ver-schwunden oder doch soweit reduziert sind, dass sie ihre Funktion nicht mehr erfüllen könnten. Ein weiteres Vorurteil bestand darin, dass die unvermeidbare Leistungsaufnahme der Halbleiterbauelemente letztlich derart sein könnte, dass es zu einer Erwärmung des flüssigen Heliums und damit zum Verlust der Supraleitung kommt. Umfangreiche Versuche der Anmelderin haben auch gezeigt, dass diese Vorurteile begründet waren, denn unter der grossen Anzahl von untersuchten Halbleiter-Bauelementen erwiesen sich im Heliumbad lediglich die LOCMOS-Bauelemente funktionsfähig.

Um ein Übersprechen auf den Zuführungsleitungen zu verhindern, wurde die aus einem Transformator und einem Widerstand gebildete Konstantstromquelle ebenfalls in das Heliumbad verlegt. Es wurde auch der Verstärker in das Heliumbad verlegt, um den Störsignalabstand zu verbessern und hochohmig auszulesen.

Als Widerstände wurden Allen-Bradley Widerstände verwendet, welche ihren Widerstand in Abhängigkeit von der Umgebungstemperatur ändern und die in flüssigem Helium einsetzbar sind.

Die Erfindung wird im folgenden anhand von Figuren näher erläutert; es zeigen:

Fig. 1 eine teilweise geschnittene Seitenansicht von 2 supraleitenden 9-zelligen Niob-Cavities für 1 GHz im Kryostaten;

Fig. 2 ein Blockschaltbild der in Verbindung mit dem Kryostaten gemäss Fig. 1 verwendeten Schaltung;

Fig. 3 ein Schemaschaltbild eines Teils des Blockschaltbilds von Fig. 2.

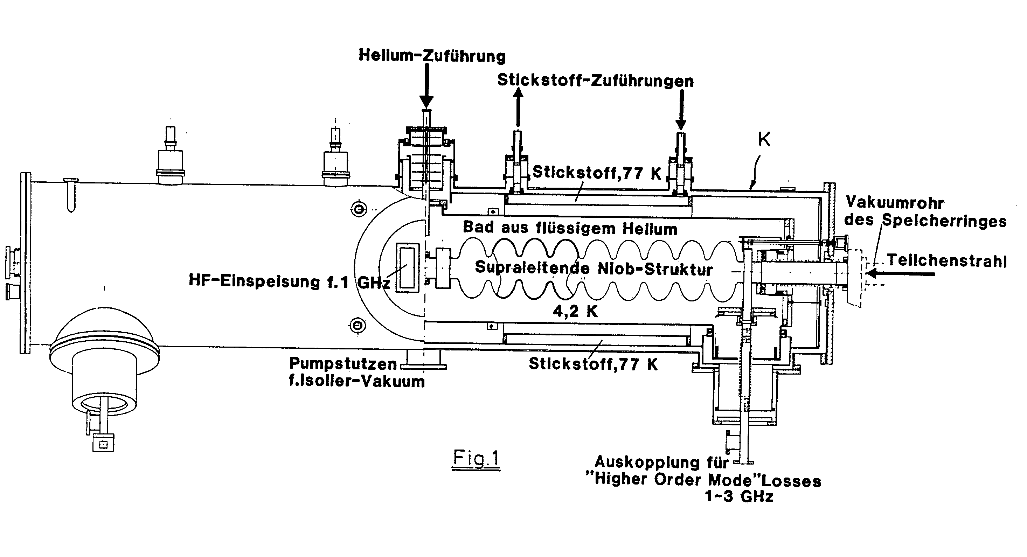

Fig. 1 zeigt eine geschnittene Teilansicht eines Hohlraumresonators im Kryostaten K, der in seinem Inneren eine supraleitende Niob-Struktur aufweist. Die supraleitende Niob-Struktur ist aus miteinander verschweissten Schalen aufgebaut, die bei der Niob-Sprungtemperatur von 9,25K supraleitend werden. Für ein Feld von 2-3MV/m braucht daher für eine Struktur mit bis zu neun Resonatoren nur eine elektrische Leistung von etwa 18W/m aufgebracht zu werden. Hierfür ist allerdings eine Kälteleistung von 9kW/m erforderlich, denn die Niob-Struktur liegt in einem Bad aus flüssigem Helium, das eine Temperatur von 4,2K hat. Zur Vorkühlung des Heliums ist der Heliumraum von einem Stickstoffraum umgeben, welcher mit flüssigem Stickstoff von 77K gefüllt wird. Der Stickstoffraum und der Heliumraum werden ausserdem noch von einem üblichen Isoliervakuumraum umgeben.

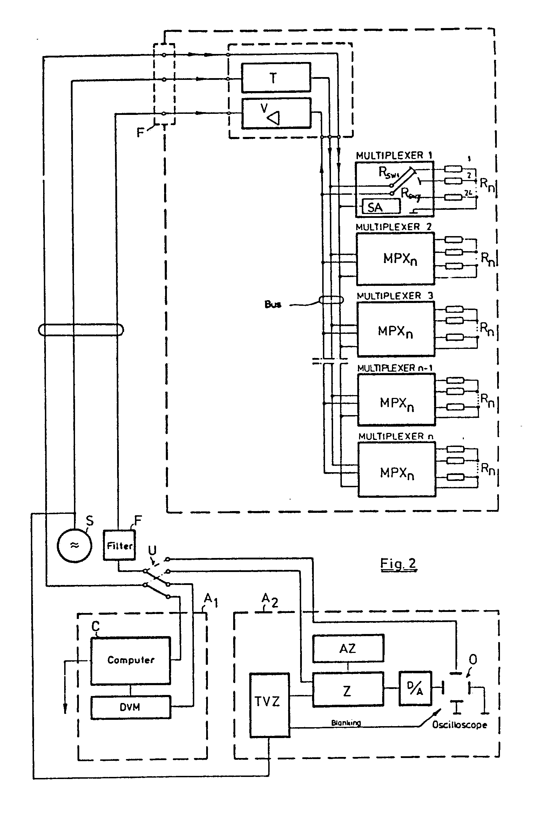

Auf der Aussenwand der Niob-Struktur sind temperaturabhängige Widerstände $R_n$ angebracht, die in Fig. 2 erkennbar sind. Die temperaturabhängigen Widerstände $R_n$ sind an sich bekannte 220 Ohm Allen-Bradley Widerstände, die bei 4,2K 4,2kOhm haben. Sie werden so eng wie möglich auf die Oberfläche der Niob-Struktur aufgelegt und dort befestigt, beispielsweise durch Klebebänder durch mechanische Verschnürungen oder auf sonstige Weise.

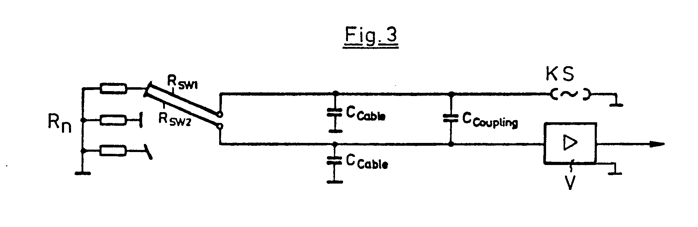

Ein Ende der Widerstände $R_n$ ist an Masse gelegt, während ihr anderes Ende gemäss Fig. 3 jeweils mit einem ersten Analogschalter $R_{SW1}$ und einem zweiten Analogschalter $R_{SW2}$ verbunden ist. Der erste Analogschalter $R_{SW1}$ ist an eine Konstantstromquelle KS angeschlossen, während der zweite Analogschalter $R_{SW2}$ mit einem Verstärker V verbunden ist. Das Ausgangssignal des Verstärkers V wird über eine Ausgabeleitung an ein ausserhalb des Kryostaten K befindliches Filter F gelegt und letztlich einer Anzeige A zugeführt.

Die Analogschalter $R_{SW1}$ und $R_{SW2}$ sind LOCMOS-Bauelemente des Typs HEF 4051. Jeweils eine grössere Anzahl von Analogschaltern $R_{SW1}$, $R_{SW2}$ ist in einem Multiplexer $MPX_n$ zusammengefasst, welcher die einzelnen Widerstände $R_n$ zeitmultiplexiert, also nacheinander ansteuert. Die jeweils zu einem Widerstand $R_n$ gehörenden ersten und zweiten Analogschalter $R_{SW1}$ und $R_{SW2}$ werden dabei jeweils gleichzeitig von einer einen Teil des Multiplexers $MPX_n$ bildenden Schalteransteuerung SA durchgeschaltet. Als im Heliumbad verwendbare Schalteransteuerungen SA wurden ebenfalls LOCMOS-Bauelemente des Typs HEF 4515 ermittelt. Die den Multiplexer $MPX_n$ bildenden Schalteransteuerungen SA und die Analogschalter $R_{SW1}$, $R_{SW2}$ sind auf Platinen mit halogenfreiem Lot verlötet, wobei die Leitungsbahnen in der Platine in an sich bekannter Weise eingebettet sind.

Fig. 2 zeigt ausserdem, dass sowohl der Transformator T als auch der Verstärker V im Kryostaten K und damit im Bad aus flüssigem Helium untergebracht sind. Als Transformator T wird zweckmässigerweise ein Schalenkerntransformator verwendet, für den Verstärker musste wiederum ein geeignetes Bauelement ausgewählt werden.

Auch hier erwies sich ein LOCMOS Verstärker des Typs HEF 4007 als geeignet, der ausserdem von PU-Schaum (Polyurethan-Schaum) umgeben wurde, um seine Arbeitstemperatur etwas zu erhöhen. Auf diese Weise brauchen nur wenige Leitungen durch die Durchführung F aus dem Kryostaten K nach aussen geführt zu werden. In einer praktischen Ausführungsform waren lediglich 30 Leitungen notwendig, welche durch die Durchführung F geführt werden mussten, um 960 Widerstände $R_n$ zu adressieren und abzufragen.

Fig. 2 zeigt ferner, dass das Filter F über einen Umschalter U mit einer langsamen bzw. mit einer schnellen Anzeige $A_1$ bzw. $A_2$ verbunden ist, und zwar einerseits mit einem Voltmeter DVM der langsamen Anzeige $A_1$ und andererseits mit einem zur schnellen Anzeige $A_2$ gehörenden Oszilloskop O. Der Umschalter U verbindet ausserdem in einer Stellung einen zur schnellen Anzeige $A_2$ gehörenden Zähler Z mit den ersten und zweiten Analogschaltern $R_{SW1}$ und $R_{SW2}$, die in der anderen Stellung des Umschalters U mit einem Computer C verbunden sind. Der Computer C und das Voltmeter DVM dienen zum langsamen Ablesen der durch die Widerstände $R_n$ gekennzeichneten Messstellen, während das Oszilloskop O ein schnelles Auslesen der Widerstände $R_n$ gestattet. Hierzu ist das Oszilloskop O beispielsweise in X-Richtung über einen Digital/Analog-Wandler D/A mit dem Zähler Z gekoppelt, der an die Analogschalter $R_{SW1}$, $R_{SW2}$ angeschlossen ist. In Y-Richtung werden die vom Verstärker V gemessenen Spannungsamplituden angezeigt, so dass das Oszilloskop O jedem Widerstand $R_n$ einen Punkt der horizontalen Achse zuordnet und in vertikaler Richtung den gemessenen Spannungswert anzeigt. Ein mit dem Zähler Z gekoppelter Adressenanzeiger AZ dient dazu, einen bestimmten Widerstand $R_x$ anzuwählen, um dessen Spannungswert auf dem Oszilloskop O getrennt anzeigen zu können. Mit dem Zähler Z ist ausserdem eine Teiler- und Verzögerungsschaltung TVZ gekoppelt, welche die Zahl der Frequenzperiode der dem Transformator T zugeführten Wechselspannung pro angewählten Widerstand festlegt.

## Patentansprüche

1. Tieftemperatur-Messschaltung mit einer Anzahl von temperaturabhängigen Widerständen ($R_n$), mit mindestens einem die Widerstände ($R_n$) ansteuernden Multiplexer ($MPX_n$), mit einer Konstantstromquelle (KS), welche die Widerstände ($R_n$) über den oder die Multiplexer ($MPX_n$) mit Strom versorgt, mit einem an den oder die Multiplexer ($MPX_n$) angeschlossenen Verstärker (V) zur Verstärkung des Spannungsabfalls über den Widerständen ($R_n$), und mit einer dem Verstärker (V) nachgeschalteten Anzeige (A) zum Anzeigen der über jedem einzelnen Widerstand ($R_n$) gemessenen Spannungen, dadurch gekennzeichnet, dass zusätzlich zu den Widerstän-

den (R$_n$), auch der oder die Multiplexer (MPX$_n$), die Konstantstromquelle (KS) und der Verstärker (V) in den im Betrieb flüssiges Helium enthaltenden Teil eines Kryostaten (K) gelegt sind und dass der oder die Multiplexer (MPX$_n$) und der Verstärker (V) in LOCMOS-Technologie ausgeführt sind.

2. Schaltung nach Anspruch 1, dadurch gekennzeichnet, dass jeder Multiplexer (MPX$_n$) erste und zweite Analogschalter (R$_{SW1}$, R$_{SW2}$) und Schalteransteuerungen (SA) enthält.

3. Schaltung nach Anspruch 2, dadurch gekennzeichnet, dass die Analogschalter (R$_{SW1}$, R$_{SW2}$) LOCMOS-Bauelemente des Typs HEF 4051 und die Schalteransteuerungen (SA) LOCMOS-Bauelemente des Typs HEF 4515 sind.

4. Schaltung nach Anspruch 1, dadurch gekennzeichnet, dass der Verstärker (V ) ein LOCMOS-Verstärker des Typs HEF 4007 ist, der von PU-Schaum umhüllt und in den im Betrieb flüssiges Helium enthaltenden Teil des Kryostaten (K) gelegt ist.

5. Schaltung nach Anspruch 1, dadurch gekennzeichnet, dass die Konstantstromquelle (KS) einen Transformator (T) und einen Widerstand aufweist und ebenfalls in den im Betrieb flüssiges Helium enthaltenden Teil des Kryostaten (K) gelegt ist.

## Claims

1. A low temperature measurement circuit having a number of temperature-dependent resistors (R$_n$), at least one multiplexer (MPX$_n$) which drives the resistors (R$_n$), a constant current source (KS) which supplies the resistors with current via the multiplexer or multiplexers (MPX$_n$), an amplifier (V) connected to the multiplexer or multiplexers (MPX$_n$) for the amplification of the voltage drop across the resistors (R$_n$), and an indicator (A) connected after the amplifier (V) for the indication of the voltages measured across each individual resistor (R$_n$), characterised in that in addition to the resistors (R$_n$) the multiplexer or multiplexers (MPX$_n$), the constant current source (KS) and the amplifier (V) are also placed in that part of a cryostat (K) which in service contains liquid helium and that the multiplexer or multiplexers (MPX$_n$) and amplifier (V) are executed in LOCMOS technology.

2. A circuit as in Claim 1, characterized in that each multiplexer (MPX$_n$) contains first and second analogue switches (R$_{SW1}$, R$_{SW2}$) and switch drives (SA).

3. A circuit as in Claim 2, characterized in that the analogue switches (R$_{SW1}$, R$_{SW2}$) are LOCMOS structural members of type HEF 4051 and the switch drives are LOCMOS structural members of type HEF 4515.

4. A circuit as in Claim 1, characterized in that the amplifier (V) is a LOCMOS amplifier of type HEF 4007 which is enveloped in PU foam and placed in that part of the cryostat (K) which in service contains liquid helium.

5. A circuit as in Claim 1, characterized in that the constant current source (KS) exhibits a transformer (T) and a resistor and is likewise placed in that part of the cryostat (K) which in service contains liquid helium.

## Revendications

1. Circuit de mesure pour les basses températures, avec un certain nombre de résistance (R$_n$) dépendant de la température, avec au moins un multiplexeur (MPX$_n$) commandant les résistances (R$_n$), avec une source de courant constant (KS) qui alimente en courant les résistances (R$_n$) en passant par le ou les multiplexeurs (MPX$_u$), avec un amplificateur (V) raccordé au ou aux multiplexeurs (MPX$_n$) pour l'amplification de la chute de courant sur les résistances (R$_n$) et avec, branché à la suite de l'amplificateur (V), un dispositif d'affichage (A) pour afficher les tensions mesurées sur chaque résistance (R$_n$) individuelle, caractérisé en ce que, aussi, en plus des résistances (R$_n$), le ou les multiplexeurs (MPX$_n$), la source de courant constant (KS) et l'amplificateur (V) sont placés dans la partie contenant de l'hélium liquide en cours d'exploitation d'un cryostat (K) et en ce que le ou les multiplexeurs (MPX$_n$) et l'amplificateur (V) sont réalisés en technologie LOCMOS.

2. Circuit suivant la revendication 1, caractérisé en ce que chaque multiplexeurs (MPX$_n$) contient de premier et second commutateurs analogiques (R$_{SW1}$, R$_{SW2}$) et des commandes (SA) de commutateurs.

3. Circuit suivant la revendication 2, caractérisé en ce que les commutateurs analogiques (R$_{SW1}$, R$_{SW2}$) sont des éléments constructifs LOCMOS du type HEF 4051 et en ce que les commandes de commutateurs (SA) sont des éléments constructifs LOCMOS du type HEF 4515.

4. Circuit suivant la revendication 1, caractérisé en ce que l'amplificateur (V) est un amplificateur LOCMOS du type HEF 4007 qui est entouré par de la mousse de polyuréthanne et qui est placé dans la partie du cryostat (K) contenant de l'hélium liquide en cours d'exploitation.

5. Circuit suivant la revendication 1, caractérisé en ce que la source de courant constant (KS) comporte un transformateur (T) et une résistance et est placé également dans la partie du cryostat (K) contenant de l'hélium liquide en cours d'exploitation.

Helium-Zuführung

Stickstoff-Zuführungen

K

Stickstoff,77 K

Vakuumrohr
des Speicherringes

Bad aus flüssigem Helium

Supraleitende Niob-Struktur

Teilchenstrahl

HF-Einspeisung f.1 GHz

4,2 K

Pumpstutzen
f.Isolier-Vakuum

Stickstoff,77 K

Fig.1

Auskopplung für
"Higher Order Mode"Losses
1-3 GHz

0 168 518

Fig. 2

<u>Fig. 3</u>